# FASCICULE DE BREVET EUROPEEN

(11) **EP 0 350 368 B1**
(45) Date de publication et mention de la délivrance du brevet: **03.03.1993**
(21) Numéro de dépôt: 89401823.3
(22) Date de dépôt: 27.06.1989
(51) Int. Cl.: H03M 13/00, G11B 20/18

(54) **Dispositif pour le codage et la mise en forme de données pour enregistreurs à têtes tournantes**
Datenkodierung und Formungsvorrichtung für ein Aufzeichnungsgerät mit drehenden Köpfen
Data coding and shaping device for a rotating-head recorder

(30) Priorité: 07.07.1988 FR 8809234
(43) Date de publication de la demande: 10.01.1990
(73) Titulaire: SCHLUMBERGER INDUSTRIES, F-92120 Montrouge (FR)
(72) Inventeur: Denoize, Xavier, F-91470 Limours (FR); Lelandais, Guy, F-91190 Gif-sur-Yvette (FR)
(74) Mandataire: Dupont, Henri

(56) Documents cités:
- WO-A-81/00316
- US-A- 4 052 698
- US-A- 4 404 676
- US-A- 4 665 537
- NHK TECHNICAL MONOGRAPH. no. 31, mars 1982, TOKYO JP pages 3 - 26; K. YOKOYAMA: "DIGITAL VIDEOTAPE RECORDER"

## Description

La présente invention concerne un dispositif électronique pour le traitement de données provenant, sous forme d'un flux d'octets, de moyens émetteurs tels que par exemple des capteurs de paramètres physiques, appareils de contrôle et/ou de régulation (disposés par exemple à bord d'un aéronef), lesdites données étant destinées à être enregistrées sur un support d'information, tel qu'une bande magnétique.

On sait que les enregistreurs dits "à têtes tournantes", auxquels s'applique le dispositif selon l'invention, comprennent un tambour cylindrique contre lequel s'enroule hélicoïdalement la bande selon un angle d'hélice donné, un disque rotatif coaxial au tambour, disposé dans une fente équatoriale et à la périphérie duquel sont fixées des têtes magnétiques faisant légèrement saillie par rapport à la surface du tambour de manière à porter sur la bande. Compte-tenu du déplacement linéaire de la bande et de la rotation des têtes, l'information est enregistrée sur la bande selon des segments de pistes obliques,appelés trames par l'homme de l'art. Les trames sont constituées selon un format donné (inclinaison, nombre de bits) et comprennent également des données d'identification et de synchronisation.

Le dispositif électrique selon l'invention, relié par son entrée auxdits moyens émetteurs et par sa sortie à une tête d'enregistrement magnétique en contact avec la bande magnétique, est destiné d'une part à mettre en forme les données pour permettre leur enregistrement sur la bande, selon un format donné, et d'autre part à coder celles-ci en vue d'assurer une correction d'erreur.

A cette fin, de façon connue, on stocke temporairement les données dans une mémoire vive (sous forme de matrice). Le codage s'effectue en calculant, pour chaque ligne et pour chaque colonne respectivement, des octets de redondance sur la base d'opérations mathématiques (connues en elles-mêmes, par exemple du type code Reed-Solomon). Ainsi, par exemple, pour une matrice 118 lignes x 153 colonnes, aux 118 octets de chaque colonne sont affectés 10 octets de redondance verticale, et aux 153 octets de chaque ligne sont affectés 8 octets de redondance horizontale.

Les octets provenant des moyens émetteurs de données sont stockés colonne par colonne les uns après les autres dans la mémoire matricielle, puis extraits de celle-ci ligne par ligne, pour être enregistrés sur la bande selon une configuration de trame donnée.

Le codage ainsi réalisé permet de retrouver ou reconstituer (par décodage) des données erronées ou perdues par suite d'une défaillance de l'enregistreur et/ou de défauts locaux sur la bande. En écrivant par colonne, puis en lisant par ligne les données de la mémoire, on s'affranchit des conséquences de la présence de plusieurs données consécutives fausses. On comprend que, plus le nombre d'octets de redondance est grand, meilleure sera la correction d'erreur, mais en contrepartie, plus long sera le temps nécessaire au codage des données.

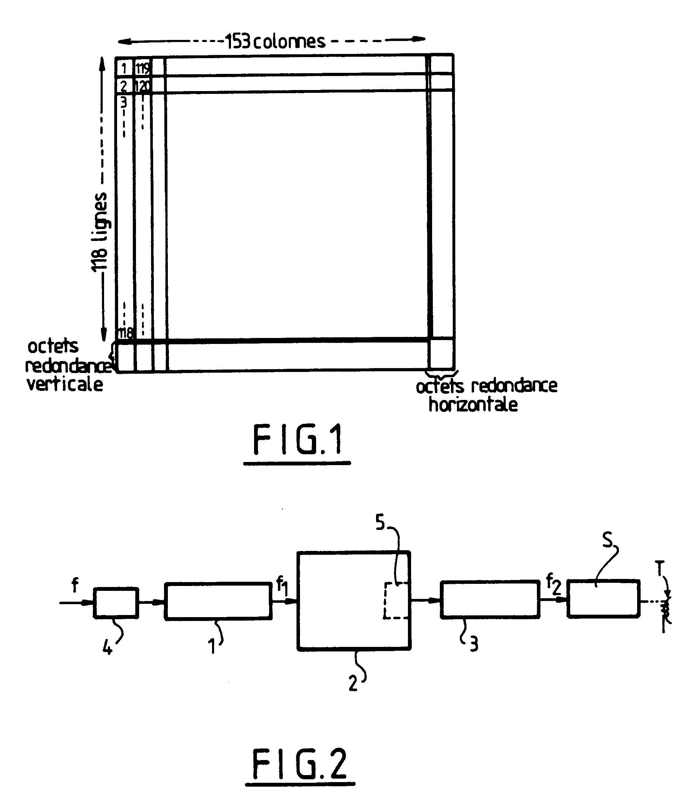

Un dispositif connu de ce type, représenté schématiquement sur la figure 2, comporte successivement un premier circuit codeur 1 destiné au codage vertical (calcul des octets de redondance verticale), une mémoire vive 2 dans laquelle les octets sont stockés sous forme matricielle, un second circuit codeur 3 destiné au codage horizontal (calcul des octets de redondance horizontale), et un circuit "S" de synchronisation et mise en forme des données, dont la sortie est reliée à une tête magnétique "T".

La mémoire 2 reçoit colonne par colonne les octets de données ainsi que les octets de redondance verticale calculés par le premier circuit codeur 1; l'ensemble de ces octets sont extraits (ou lus) de la mémoire 2 ligne par ligne et injectés dans le second circuit codeur 3 qui calcule les octets de redondance horizontale ; le second circuit codeur 3 délivre à sa sortie les octets de redondance horizontale et le contenu de la mémoire 2. L'ensemble des octets de données, des octets de redondance verticale et des octets de redondance horizontale est alors traîté par le circuit S avant d'être enregistré sur bande par la tête magnétique T.

Ce dispositif connu présente des inconvénients.

En effet, soit "f" la fréquence du flux de données arrivant au circuit codeur 1 vertical, le flux en sortie de ce dernier est associé à une fréquence f₁= f (118+10)/118 (pour une matrice 118 lignes, 10 octets de redondance verticale); f₁ est supérieur à f. En conséquence, il est prévu, en amont du premier circuit codeur 1, un circuit 4 de "compression de données", apte à ménager de façon périodique un intervalle de temps "vierge" auxquels seront affectés les octets de redondance verticale calculés. De même, le circuit codeur 3 horizontal reçoit sur son entrée un flux de données de fréquence f₁, et sa sortie délivre un flux de fréquence f₂= f (118+10)/118 x (153+8)/153 (f₂ est donc supérieur à f₁). La mémoire 2 assure également une fonction permettant le changement de fréquence de f₁ en f₂, et que l'on peut considérer réalisée sous la forme d'un second circuit de compression de données 5, virtuellement intégré dans la mémoire 2 ; de tels circuits de "compression de données" sont plus connus sous l'acronyme anglais FIFO (first-in first-out buffer memory).

L'obligation de prévoir de tels circuits de compression de données complique l'ensemble du dispositif.

En outre, il découle de ce qui précède que le circuit codeur vertical traite les données à une fréquence différente de celle du circuit codeur horizontal. Ceci augmente la complexité de réalisation de ces deux circuits.

Par ailleurs, l'évolution du domaine technique de l'enregistrement auquel s'applique ce type de dispositif tend vers des valeurs de plus en plus élevées de flux, par exemple de plusieurs centaines de Megabit/s et même de un Gigabit/s.

Or, du fait de la différence de fréquence (associée au flux) entre l'entrée et la sortie du premier circuit codeur, ce dernier présente une limite supérieure de fonctionnement en fréquence, de valeur inférieure à celles requises (mentionnées ci-dessus). Pour atteindre ces dernières, on pourrait penser à multiplier les voies d'entrée, afin que le circuit codeur traite les données en parallèle. Cependant, ceci ne serait possible qu'au prix d'une complexité accrue de ce dernier. En toute hypothèse, la "technologie" électronique impose une limite quant au nombre d'octets qu'il est possible de traiter en parallèle.

L'invention vise à remédier à cet inconvénient et propose un circuit de codage et de mise en forme de données, simple de réalisation et de fonctionnement et susceptible de fonctionner à des valeurs élevées de flux de données.

A cette fin, selon l'invention, le dispositif pour le codage et la mise en forme de données, apte à recevoir sur son entrée un flux de données disposées sous forme d'octets, comprenant d'une part une mémoire vive dans laquelle les données sont stockées sous forme d'une matrice, puis extraites les unes après les autres, les opérations de stockage et d'extraction étant effectuées respectivement selon des séquences différentes (soit par lignes puis colonnes, soit par colonnes puis par lignes), et d'autre part un premier moyen codeur et un second moyen codeur aptes chacun à calculer, pour respectivement chaque ligne et chaque colonne, un nombre donné d'octets de redondance respectivement horizontale et verticale, le premier moyen codeur affecté au calcul de redondance de la séquence par laquelle les données sont extraites de la mémoire étant relié à la sortie de ladite mémoire, est caractérisé en ce que les premier et second moyens codeurs sont reliés en parallèle à la sortie de la mémoire, ledit second moyen codeur affecté au calcul de redondance de séquence opposée à celle par laquelle les données sont extraites de la mémoire étant apte à mettre en mémoire les calculs partiels effectués par ce dernier.

Aux avantages mentionnés précédemment de l'invention, s'ajoute celui de permettre la réalisation des deux circuits codeurs dans un ensemble électronique unique.

Selon une forme de réalisation préférée, le second moyen codeur comprend un circuit codeur et une mémoire additionnelle associée.

En variante, le second moyen codeur est constitué d'une pluralité de circuits codeurs, en nombre égal au nombre de lignes (respectivement de colonne) de la matrice de la mémoire.

Afin de permettre le traitement d'un flux élevé de données, le dispositif comprend au moins deux ensembles modulaires comportant chacun une mémoire dont la sortie est reliée à deux circuits codeurs en parallèle, chaque couple de circuits codeurs étant relié à la sortie de chaque mémoire.
- La figure 1 est un schéma d'une matrice de données et des octets de redondance ;
- La figure 2 est un schéma synoptique d'un dispositif de l'art antérieur ;
- La figure 3 est un schéma synoptique d'un dispositif selon l'invention ;
- La figure 4 est un schéma d'un dispositif selon l'invention pourvu de quatre ensembles en parallèle selon la figure 3;
- La figure 5 montre des diagrammes de fonctionnement du dispositif de la figure 4;
- La figure 6 est un schéma d'une variante améliorée d'un dispositif selon l'invention permettant le traitement d'un flux important de données ; et
- La figure 7 est un schéma montrant l'écriture des données dans les quatre mémoires associées des voies A et B du dispositif de la figure 6.

L'invention s'applique au codage et la mise en forme de données constituées d'un flux d'informations, disposées sous forme de bits groupés en octets, provenant d'appareils de mesure, de contrôle ou analogue, et destinées à être enregistrées (par exemple sur bande). Le flux de données peut être, soit continu, soit discontinu (ou par "paquets"). De façon connue, les données sont codées, à des fins de correction d'erreurs, en affectant à chaque ligne, respectivement chaque colonne, un certain nombre d'octets de redondance, calculés par des opérations mathématiques connues en elles-mêmes (du type par exemple code REED-SOLOMON). Les octets sont stockés dans une mémoire vive colonne par colonne, puis lus (ou extraits) de la mémoire ligne par ligne.

La figure 1 montre schématiquement une mémoire sous forme d'une matrice comprenant 118 lignes et 153 colonnes de données notées 1, 2, 3, ....., 118, 119, 120, ..... A chaque colonne, sont affectés dix octets de redondance verticale, tandis que chaque ligne est associée à huit octets de redondance horizontale. Ainsi, l'ensemble des octets constituant l'information proprement dite et des octets de redondance (verticale et horizontale) forment un ensemble de 118+10 lignes et 153+8 colonnes.

Sur la figure 2 est représenté une vue synoptique d'un dispositif selon l'art antérieur, et déjà décrit précédemment.

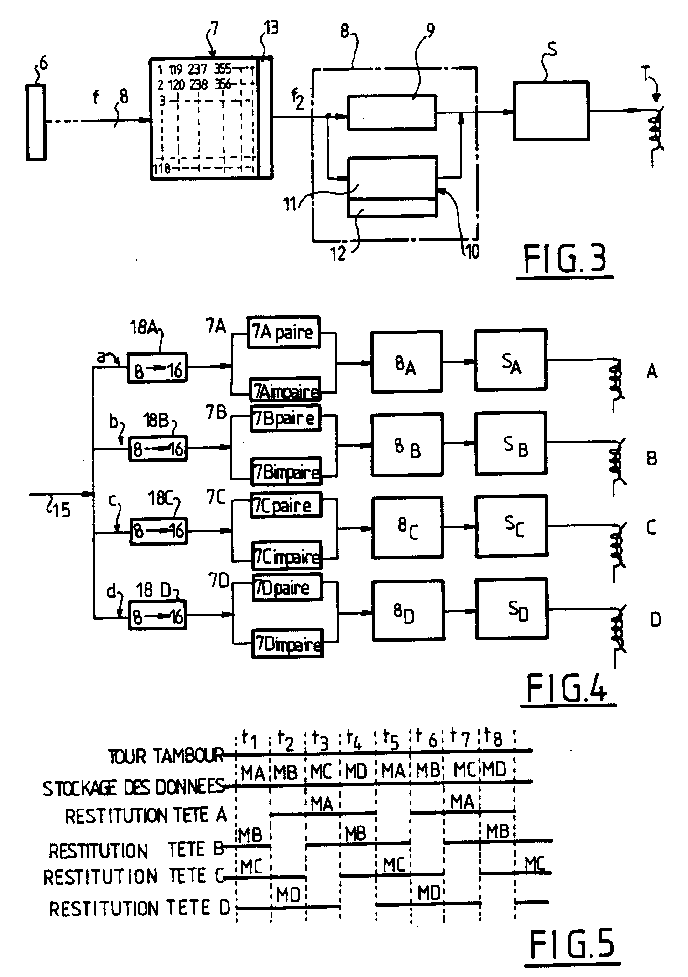

Un exemple de réalisation du dispositif selon l'invention est montré de façon schématique sur la figure 3.

Le dispositif, relié à des moyens 6 d'émission de données , connus en eux-mêmes, comprend une mémoire vive 7 dans laquelle les octets sont stockés colonnes par colonnes sous forme matricielle et dont la sortie est reliée à un bloc fonctionnel de codage 8; ce dernier comprend des premiers moyens de codage 9 et des second moyens de codage 10 disposés en parallèlle l'un sur l'autre. Les premiers moyens de codage sont affectés au calcul des octets de redondance horizontale, et sont constitués d'un premier circuit codeur 9, appelé par la suite circuit codeur horizontal 9. Les second moyens de codage 10 sont affectés au calcul des octets de redondance verticale, et sont constitués d'un second circuit codeur 11 (appelé par la suite circuit codeur vertical 11) et d'une mémoire auxilliaire 12, du même type que la mémoire 7, mais de taille réduite.

La mémoire 7 est conçue de manière à permettre un changement de fréquence, depuis la fréquence "f" du flux de données à l'entrée de la mémoire 7, vers la fréquence f2 (en sortie de mémoire) f2 = f (118+10)/118 x (153x8)/153. A cette fin, on considère que la mémoire 7 est virtuellement pourvue d'un circuit 13 de compression de données (FIFO), intégré dans la mémoire 7, du type de celui décrit précédemment et connu en lui-même.

Ainsi, au fur et à mesure que les octets sont extraits ligne par ligne de la mémoire 7, les circuits codeurs horizontal 9 et vertical 11 effectuent en parallèlle les calcul des octets de redondance respectivement horizontale et verticale. Pour une matrice d'octets (constituant l'information proprement dite) de 118 lignes et 153 colonnes, la première ligne de la mémoire 7 comprend successivement les octets représentés sur la figure 3 par les nombres 1, 119, 237, 355,... . Ces derniers sont extraits de la mémoire et appliqués simultanément d'une part au circuit codeur horizontal 9 qui calcule les octets de redondance horizontale relatifs à cette première ligne, et d'autre part au circuit codeur vertical 10 qui stocke les octets reçus dans la mémoire auxiliaire 12. Le circuit codeur horizontal 9 délivre l'ensemble des octets 1, 119,.. et les huit octets de redondance horizontale.

Les octets de la ligne suivante (octets 2, 120, 238, 356, ...) sont ensuite extraits de la mémoire 7 et reçus à la fois par le codeur horizontal 9 qui calcule les octets de redondance horizontale relatifs à la seconde ligne, et par le codeur vertical. Ce dernier, au fur et à mesure de l'arrivée des octets de la seconde ligne, effectue un calcul partiel des octets de redondance verticale qui sont mis en mémoire dans la mémoire auxiliaire 12 (octet 2 combiné avec l'octet 1 pour le calcul partiel d'octets de redondance verticale de la première colonne ; de même avec les octets 119 et 120 pour la seconde colonne, puis les octets 237 et 238 de la troisième colonne).

A la fin de cette seconde étape (lorsque la première ligne est extraite) le codeur horizontal 9 délivre les octets de données (2, 120, 238, 356, ...) et les octets de redondance horizontale, tandis que la mémoire auxiliaire 12 du codeur vertical 10 contient les calculs partiels des octets de redondance verticale.

Les étapes se poursuivent ainsi ligne par ligne jusqu'à ce que l'ensemble des octets de la mémoire soient extraits. A noter que, dans le cas d'espèce, l'écriture des données dans la mémoire et la lecture sont des opérations simultanées.

La mémoire auxiliaire 12 a été représentée et décrite comme associée au circuit codeur vertical 10 ; ceci correspond au cas particulier où les octets sont extraits ligne par ligne de la mémoire. En fait, la mémoire auxiliaire 12 est associée à celui des circuits codeurs calculant les octets de redondance correspondant à la séquence (ligne ou colonne) opposée à celle par laquelle les octets sont extraits de la mémoire.

L'invention présente des avantages par rapport à l'art antérieur.

En effet, aucun circuit de compression de données (FIFO) n'est nécessaire, la fonction de changement de fréquence étant intégrée dans la mémoire. Ceci simplifie sensiblement la réalisation.

De plus, les circuits codeurs respectivement horizontal 9 et vertical 11, d'une part fonctionnent à la même fréquence, et d'autre part sont proches physiquement l'un de l'autre. Ce rapprochement fonctionnel et physique permet de réaliser l'ensemble de codage 8 sur un même ensemble électronique, avec les avantages de simplification, et de réduction d'encombrement et de coût qui en résultent.

Enfin et surtout, le dispositif selon l'invention permet de traiter des données transmises avec des valeurs de flux (en nombre de bits par seconde) élevées. En effet, afin d'augmenter la valeur possible du flux de données susceptibles d'être traitées, on dispose en parallèle plusieurs ensembles modulaires, du type de celui montré sur la figure 3; ce dernier étant suceptible de traîter un flux de quelques dizaines de Mbit/s, par exemple 30 Mbit/s, on peut ainsi multiplier ce nombre par le nombre d'ensembles mis en parallèlle.

Un tel dispositif, pourvu de quatre ensembles modulaires selon la figure 3, est montré sur la figure 4.

Le dispositif comprend une ligne 15 recevant le flux d'informations et se séparant en quatre voies a,b,c,d aboutissant à des têtes magnétiques respectivement A,B,C et D, et comprenant chacune successivement un circuit 18, une mémoire 7, un ensemble de codage 8 et des moyens de synchronisation. La cadence susceptible d'être traitée par la mise en parallèle de quatre ensembles selon la figure 3, est théoriquement de 30 Mbit/s x 4 = 120 Mbit/s.

La cadence est limitée, pour des raisons technologiques, par la fréquence maximale de travail des mémoires, en l'occurence de l'ordre de 15 MHz, ce qui correspond à 15 Mega octets/s avec 1 octet = 8 bits ; ainsi 120 Mbit/s = 15 Moctet/s.

Une cadence double, de 240 Mbit/s, correspondrait à une fréquence de 30 MHz incompatible avec les limites de fonctionnement des mémoires. Il est cependant possible d'obtenir une telle cadence 240 Mbit/s avec le dispositif de la figure 4 grâce aux moyens référencés 18A,18B,18C,18D (disposés sur les voies respectives a,b,c,d) aptes à transformer les octets de 8 bits en octets de 16 bits. Ainsi, le flux de 240 Mbit/s correspond à 15 Moctet de 16 bits par seconde, et à une fréquence de 15 MHz. Ceci nécessite de faire appel pour chaque voie à deux mémoires, respectivement paire et impaire, disposées en parallèle et traitant respectivement les octets pair et impair. Chaque mémoire 7A,7B,7C, et 7D est constituée de deux mémoires en parallèle 7A paire et 7A impaire pour la voie a, 7B paire et 7B impaire pour la voie b, 7C paire et 7C impaire pour la voie c, et 7D paire et 7D impaire pour la voie d.

La figure 5 montre un synoptique temporel des périodes de fonctionnement des mémoires (stockage des données) et des têtes (restitution sur la bande par la tête correspondante). Une révolution des têtes autour du tambour comprend quatre périodes égales t₁ à t₄, puis t₅ à t₈. Pendant t₁ les données sont stockées dans la mémoire 7A tandis que les données sont extraites des mémoires 7B,7C et 7D et transmises aux têtes B,C et D pour écriture sur la bande ; de même, pendant les périodes suivantes, les données sont écrites dans une mémoire pendant que les trois autres mémoires sont lues.

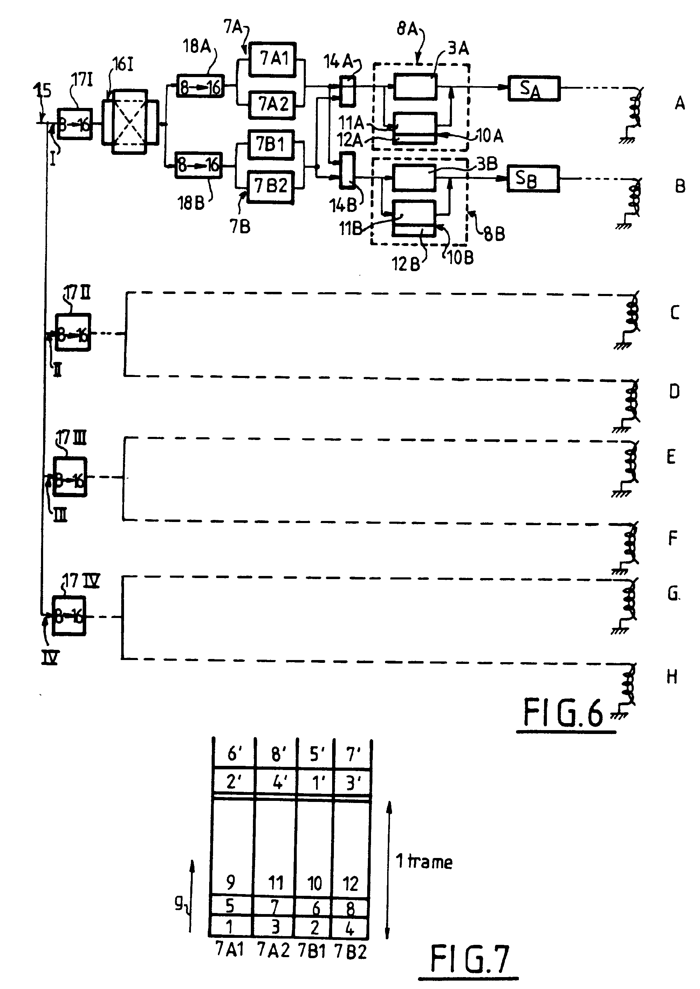

L'invention présente en outre d'autres caractéristiques, décrites ci-après en référence à la figure 6, permettant d'augmenter encore la cadence de données susceptibles d'être traitées, à l'aide de moyens simples.

A partir du dispositif selon la figure 4, susceptible de traiter à une cadence de 240 Mbit/s, le traitement à cadence double (480 Mbit/s) nécessite huit voies (similaires aux voies a,b,c,d de la figure 4) aboutissant chacune à une tête, les circuits 18 étant alors aptes à transformer les octets (de 8 bits) en mots de 32 bits. Les limites, mentionnées ci-dessus, de fonctionnement à 15 MHz des mémoires, obligent à prévoir, non plus deux mémoires en parallèle comme sur la figure 4, mais quatre mémoires en parallèle.

Le dispositif que l'on aurait ainsi réalisé, bien que apte à traiter à une cadence double de celle du dispositif de la figure 4, n'en présenterait pas moins des inconvénients. En effet, dans les quatre mémoires d'une voie serait stockée une trame soit 2 x (153 x 118) octets ; chaque mémoire serait donc amenée à stocker un nombre d'octets deux fois plus petit que dans le cas de la figure 4. Ceci conduirait à utiliser soit des mémoires de taille réduite qui présentent chacune le même encombrement que celle de la figure 4, soit des mémoires de même taille que celles de la figure 4, celles-ci n'étant alors utilisées qu'à moitié.

Aucune de ces deux solutions n'est satisfaisante.

Le dispositif selon l'invention représenté sur la figure 6 se propose de remédier à cet inconvénient.

Le dispositif comprend une ligne 15 émettant les données à la cadence de 480 Mbit/s, divisée en quatre sous-lignes I,II,III et IV elles-mêmes divisées chacune en deux voies. Chaque sous-ligne I,II,III et IV comprend un circuit transformateur de 8 bits en 16 bits référencé respectivement 17I,17II,17III et 17IV. Les éléments similaires des figures 4 et 6 portent les mêmes références; sur la figure 6 les références sont affectées de l'indice A pour les éléments disposés sur la voie a, et de l'indice B pour les éléments disposés sur la voie b.

Chaque voie comprend successivement un circuit transformateur de 8 bits en 16 bits respectivement 18A et 18B, une mémoire vive respectivement 7A, 7B, un multiplexeur respectivement 14A, 14B, un ensemble de codage respectivement 8A, 8B. La sortie de chaque mémoire 7A, 7B est reliée, via les multiplexeurs respectifs 14A, 14B, aux entrées de chaque ensemble de codage. Pour des raisons de clarté, seules les voies a et b ont été complètement représentées.

Au lieu d'une relation biunivoque entre une tête et un ensemble de mémoires, comme dans le dispositif de la figure 4, le dispositif de la figure 6 fonctionne de manière que les voies sont couplées deux à deux, deux ensembles de codage (8A et 8B) fonctionnent ainsi en parallèle.

Chaque couple de mémoire (7A1,7A2 ou 7B1,7B2) d'une voie est apte à stocker une trame ; les deux couples de mémoire sur une sous-voie peut stocker au total deux trames.

Les octets sont groupés par paires 1-2, 3-4, 5-6, etc., les octets pairs et impairs sont dirigés sur les voies respectives A et B. La mémoire 7A1 stocke les octets 1, 5, 9, etc. ; la mémoire 7A2 stocke les octets 3, 7, 11, etc. ; la mémoire 7B1 stocke les octets 2, 6, 10, etc. ; la mémoire 7B2 stocke les octets 4, 8, 12, etc. La figure 7 montre schématiquement l'écriture en mémoire des octets, la flèche g donnant le sens d'écriture en fonction du temps.

Une fois un nombre d'octets correspondant à une trame entière (2 x 153 x 118) stocké dans les quatre mémoires, des moyens de permutation 16I assurent une inversion d'aiguillage entre les couples 7A1,7A2 et 7B1,7B2 de mémoires. Cette permutation est réalisée au moment d'écrire le premier octet de la deuxième trame. Ainsi, comme montré sur la figure 7, le premier octet de la deuxième trame stocké dans la mémoire 7A1 est l'octet 2′ (le second chronologiquement de la deuxième trame).

On évite ainsi aux ensembles de codage de lire dans une même mémoire des octets de même ordre (premier, second, etc.) de deux trames consécutives.

L'invention est suceptible de présenter des variantes. En effet, dans les exemples de réalisation montrés sur les figures et décrit précédemment, le second moyen de codage 11 est constitué d'un circuit codeur 10 et d'une mémoire auxiliaire 12. En variante, le second moyen de codage 11 (vertical) peut être constitué d'une pluralité de circuits codeurs 10i (i=1 à n) disposés en parallèle les uns sur les autres et en nombre "n" égal au nombre de colonnes ; ainsi, chaque circuit codeur 10i calcule les octets de redondance verticale pour chaque colonne respectivement, et ce au fur et à mesure de l'extraction par ligne des octets de la mémoire 7 (de la manière décrite précédemment).

## Revendications

1. Dispositif pour le codage et la mise en forme de données, apte à recevoir sur son entrée un flux de données disposées sous forme d'octets, comprenant d'une part une mémoire vive (7) dans laquelle les données sont stockées sous forme d'une matrice, puis extraits les unes après les autres, les opérations de stockage et d'extraction étant effectuées respectivement selon des séquences différentes, soit par lignes puis colonnes, soit par colonnes puis par lignes, et d'autre part un premier moyen codeur (9) et un second moyen codeur (10) aptes chacun à calculer, pour respectivement chaque ligne et chaque colonne, un nombre donné d'octets de redondance respectivement horizontale et verticale, le premier moyen codeur (9) affecté au calcul de redondance de la séquence par laquelle les données sont extraites de la mémoire étant relié à la sortie de ladite mémoire, caractérisé en ce que les premier (9) et second (10) moyens codeurs sont reliés en parallèle à la sortie de la mémoire (7), ledit second moyen codeur affecté au calcul de redondance de séquence opposée à celle par laquelle les données sont extraites de la mémoire étant apte à mettre en mémoire (12) les calculs partiels effectués par ce dernier.

2. Dispositif selon la revendication 1, caractérisé en ce que le second moyen codeur comprend un circuit codeur (11) et une mémoire additionnelle associée (12).

3. Dispositif selon la revendication 1, caractérisé en ce que le second moyen codeur est constitué d'une pluralité de circuits codeurs, en nombre égal au nombre de lignes respectivement de colonne de la matrice de la mémoire.

4. Dispositif selon l'une des revendications 1 à 3, caractérisé en ce qu'il comprend au moins deux voies aboutissant chacune à une tête magnétique, chaque voie comprenant une mémoire reliée aux premier et second moyens de codage.

5. Dispositif selon la revendication 4, caractérisé en ce que chaque voie (a,b) est reliée à une tête magnétique (A,B) et comprend un couple de mémoire (7A1-7A2; 7B1-7B2) dont la sortie est reliée aux premier et second moyens codeurs en parallèlle (9A-10A; 9B-10B), la sortie du couple de mémoire disposé sur une voie étant reliée, par un circuit de multiplexage (14A, 14B), à l'entrée des premier et second moyens codeurs de l'autre voie, le dispositif étant en outre pourvu de moyens de commutation (16I) disposés en amont des mémoires et aptes à permuter l'ordre d'écriture des données dans les couples de mémoire.

6. Dispositif selon l'une des revendications précédentes, caractérisé en ce que la sortie des premier et second moyens codeurs en parallèle est reliée à une tête magnétique via des moyens de synchronisation (S).

7. Dispositif selon l'une des revendications 1 à 6, caractérisé en ce que les premier et second moyens codeurs sont réalisés dans un ensemble électronique unique.

## Patentansprüche

1. Vorrichtung zur Kodierung und Formatierung von Daten, die an ihrem Eingang einen Fluß von Daten in der Form von Oktetten empfängt und einerseits einen Schreib/Lese-Speicher (7) umfaßt, in dem die Daten in Form einer Matrix gespeichert werden, um anschließend nacheinander ausgelesen zu werden, wobei die Speicher- und Ausleseoperationen entsprechend unterschiedlichen Sequenzen durchgeführt werden, entweder zeilenweise und dann entsprechend spaltenweise oder spaltenweise und dann entsprechend zeilenweise, und andererseits erste Kodiermittel (9) und zweite Kodiermittel (10) aufweist, die jeweils dazu ausgelegt sind, für jeweils jede Zeile und jede Spalte eine vorgegebene Anzahl von horizontalen bzw. vertikalen Redundanzoktetten zu berechnen, wobei die ersten Kodiermittel (9), die zur Berechnung der Redundanz der Sequenz bestimmt sind, mit der die Daten aus dem Speicher ausgelesen werden, mit dem Ausgang des Speichers verbunden sind, dadurch gekennzeichnet, daß die ersten (9) und zweiten (10) Kodiermittel zueinander parallel mit dem Ausgang des Speichers (7) verbunden sind und daß die zweiten Kodiermittel, die zur Berechnung der Redundanz der Sequenz bestimmt sind, die der, mit der die Daten aus dem Speicher ausgelesen werden, entgegengesetzt ist, dazu ausgelegt sind, die durch diese letzteren erhaltenen partiellen Rechenergebnisse zu speichern (12).

2. Vorrichtung nach Anspruch 1, dadurch gekennzeichnet, daß die zweiten Kodiermittel einen Kodierschaltkreis (11) und einen zugeordneten zusätzlichen Speicher (12) umfassen.

3. Vorrichtung nach Anspruch 1, dadurch gekennzeichnet, daß die zweiten Kodiermittel durch eine Mehrzahl von Kodierschaltkreisen gebildet sind, deren Anzahl gleich der Zahl von Zeilen bzw. Spalten der Matrix des Speichers ist.

4. Vorrichtung nach einem der Ansprüche 1 bis 3, dadurch gekennzeichnet, daß sie zumindest zwei jeweils zu einem Magnetkopf führende Kanäle umfaßt, wobei jeder Kanal einen Speicher aufweist, der mit den ersten und zweiten Kodiermitteln verbunden ist.

5. Vorrichtung nach Anspruch 4, dadurch gekennzeichnet, daß jeder Kanal (a, b) mit einem Magnetkopf (A, B) verbunden ist und ein Speicherpaar (7A1-7A2; 7B1-7B2) umfaßt, dessen Ausgang mit den zueinander parallelen ersten und zweiten Kodiermitteln (9A-10A; 9B-10B) verbunden ist, daß der Ausgang des in einem Kanal angeordneten Speicherpaares über einen Multiplexschaltkreis (14A, 14B) mit dem Eingang der ersten und zweiten Kodiermittel des anderen Kanals verbunden ist, und daß die Vorrichtung überdies mit Umschaltmitteln (161) ausgestattet ist, die vor den Speichern angeordnet und dazu ausgelegt sind, die Reihenfolge des Einschreibens von Daten in die Speicherpaare umzukehren.

6. Vorrichtung nach einem der vorhergehenden Ansprüche, dadurch gekennzeichnet, daß der Ausgang der zueinander paralellen ersten und zweiten Kodiermittel über Synchronisationsmittel (S) mit einem Magnetkopf verbunden ist.

7. Vorrichtung nach einem der Ansprüche 1 bis 6, dadurch gekennzeichnet, daß die ersten und zweiten Kodiermittel in einer einzigen elektronischen Einheit verwirklicht sind.

## Claims

1. A circuit for encoding and formatting data, the circuit having an input suitable for receiving a data stream in the form of bytes, the circuit comprising firstly a working memory (7) in which the data is stored in the form of a matrix, and from which the data is taken sequentially, with the data being stored and taken by means of respective different sequences, either by being stored in lines and then taken in columns or else by being stored in columns and then taken in lines, and secondly first encoder means (9) and second encoder means (10) each suitable for calculating, respectively for each line and for each column, a given number of redundancy bytes which are respectively horizontal redundancy bytes and vertical redundancy bytes, the first encoding means (9) being assigned to redundancy calculations of the sequence by which the data is taken from the memory, the first encoding means (9) being connected to the output of said memory, the circuit is characterized in that the first (9) and second (10) encoding means are connected in parallel to the output from the memory (7), with said second encoding means for performing redundancy calculations corresponding to the sequence opposite to that by which the data is taken from the memory being suitable for storing in a memory (12) intermediate results in the calculations performed thereby.

2. A circuit according to claim 1, characterized in that the second encoding means comprises an encoding circuit (11) associated with addditional memory (12).

3. A circuit according to claim 1, characterized in that the second encoding means is constituted by a plurality of encoding circuits, with the number of encoding circuits being equal to the number of lines or columns as the case may be in the memory matrix

4. A circuit according to any one of claims 1 to 3, characterized in that it comprises at least two paths each terminating at a corresponding magnetic head, each path including a memory connected to first and second encoding means.

5. A circuit according to claim 4, characterized in that each path (a,b) is connected to a magnetic head (A, B) and comprises a pair of memories (7A1-7A2; 7B1-7B2) whose output is connected to the first and second encoding means in parallel (9A-10A; 9B-10B), with the output from the memory pair in a given path being connected via a multiplexing circuit (14A, 14B) to the input of the first and second encoding means of the other path, the circuit also being provided with switching means (16I) disposed upstream from the memories and suitable for interchanging the order in which data is written into the memory pairs.

6. A circuit according to any preceding claim, characterized in that the output from the first and second parallel-connected encoding means is connected to a magnetic head via synchronization means (S).

7. A circuit according to any one of claims 1 to 6, characterized in that the first and second encoding means are implemented in a single electronic assembly.
